# EUROPÄISCHE PATENTSCHRIFT

(11) **EP 3 638 639 B1**
(45) Veröffentlichungstag und Bekanntmachung des Hinweises auf die Patenterteilung: **31.08.2022**
(21) Anmeldenummer: 18731088.3
(22) Anmeldetag: 13.06.2018
(51) Int. Cl.: C04B 35/117, C04B 35/636, C04B 41/88, C04B 41/00, C04B 41/51, H05K 1/03, H05K 3/18, C04B 111/00

(54) **VERFAHREN ZUR HERSTELLUNG EINES SCHALTUNGSTRÄGERS**
METHOD FOR PRODUCING A CIRCUIT CARRIER
PROCÉDÉ DE FABRICATION D'UN SUPPORT DE CIRCUIT

(30) Priorität: 13.06.2017 DE 102017209993
(43) Veröffentlichungstag der Anmeldung: 22.04.2020
(73) Patentinhaber: Friedrich-Alexander-Universität Erlangen-Nürnberg, 91054 Erlangen (DE)
(72) Erfinder: BACHY, Bassim, 91058 Erlangen (DE); FRANKE, Jörg, 91080 Marloffstein (DE); FU, Zongwen, 91058 Erlangen (DE); GREIL, Peter, 91085 Weisendorf (DE); LI, Wang, 91074 Herzogenaurach (DE); SÜSS-WOLF, Robert, 90473 Nürnberg (DE); TRAVITZKY, Nahum, 90409 Nürnberg (DE)
(74) Vertreter: FDST Patentanwälte
(86) Internationale Anmeldenummer: PCT/EP2018/065675
(87) Internationale Veröffentlichungsnummer: WO 2018/229138

(56) Entgegenhaltungen:
- US-A- 3 180 756
- US-A1- 2007 142 530
- Wolfgang Eberhardt ET AL: "Laserdirektstrukturierung von spritzgegossenen keramischen 3D-Schaltungsträgern (Ladisk)", Abschlussbericht IGF Vorhaben 488ZN, 2015, Seiten 1-57, XP055504254, Gefunden im Internet: URL:https://www.hahn-schickard.de/fileadmi n/media/xx_Publikationen/Abschlussberichte /2015_Hahn-Schickard_Abschlussbericht_IGF- Vorhaben_Nr_488_LADISK.pdf [gefunden am 2018-09-04] in der Anmeldung erwähnt
- SHAFEEV G A: "LASER ACTIVATION AND METALLISATION OF OXIDE CERAMICS", ADVANCED MATERIALS FOR OPTICS AND ELECTRONICS, WILEY AND SONS LTD, CHICHESTER, GB, Bd. 2, Nr. 4, Juli 1993 (1993-07), Seiten 183-189, XP000384608, ISSN: 1057-9257, DOI: 10.1002/AMO.860020405
- YANG JONG-UK ET AL: "Selective metallization on copper aluminate composite via laser direct structuring technology", COMPOSITES:PART B, ELSEVIER, AMSTERDAM, NL, Bd. 110, 16. November 2016 (2016-11-16), Seiten 361-367, XP029923966, ISSN: 1359-8368, DOI: 10.1016/J.COMPOSITESB.2016.11.041

## Beschreibung

Die Erfindung betrifft ein Verfahren zur Herstellung eines Schaltungsträgers mit einem Trägersubstrat. Des Weiteren betrifft die Erfindung ein Trägersubstrat für einen keramischen Werkstoff, eine Verwendung eines keramischen Werkstoffes als Trägersubstrat, sowie den keramischen Werkstoff als solchen.

Zur Herstellung von Schaltungsträgern und insbesondere von spritzgegossenen Schaltungsträgern werden üblicherweise thermoplastische Kunststoffe eingesetzt, die mit Metallverbindungen versehene Additive enthalten. Die Fertigung der Schaltungsträger erfolgt üblicherweise mittels der sogenannten Laser-Direkt- Strukturierung (LDS-Verfahren). Hierbei schreibt ein Laserstrahl ein gewünschtes Layout direkt auf die Oberfläche eines entsprechenden kunststoffbasierten Trägersubstrats. An den Stellen, an welchen der Laserstrahl auf den Kunststoff trifft, wird der Kunststoff oberflächlich in flüchtige Spaltprodukte zersetzt und geringfügig abgetragen. Gleichzeitig werden aus dem Additiv Metallkeime abgespalten, die feinst verteilt in der mikrorauen Oberfläche liegen. Diese Metallkeime dienen als Katalysator für die nachfolgende Metallisierung. In einem stromlosen Kupferbad entsteht ein Leiterprofil bzw. eine Leiterstruktur konturenscharf auf den gelaserten Teilbereichen der Oberfläche. Nacheinander lassen sich so Schichten aus Kupfer, Nickel und abschließend Gold (Cu/Ni/Au-Beschichtung) aufbringen.

Aufgrund der begrenzten thermischen Stabilität solcher kunststoffbasierten Schaltungsträger ist den Einsatzbereich jedoch eingeschränkt. Insbesondere in Bereichen, in denen Schaltungsträger hohen Belastungen ausgesetzt sind, wie beispielsweise in der Medizintechnik, in der Luftfahrt- und Raumfahrt, in der Automobilindustrie oder bei deren Einsatz in LED-basierten Beleuchtungskörpern sind vielmehr Schaltungsträger notwendig, die sich durch gute chemische, thermische und mechanische Stabilität sowie durch einen geringen thermischen Ausdehnungskoeffizienten auszeichnen.

Eine für solche Einsatzzwecke geeignete Alternative stellen Schaltungsträger aus keramischen Werkstoffen dar. Zu deren Herstellung werden häufig das Siebdruckverfahren oder LTCC (Low Temperature Cofired Ceramics) und HTCC (High Temperature Cofired Ceramics)-Techniken genutzt. Allerdings sind die keramischen Trägersubstrate bei diesen Verfahren hinsichtlich in ihrer Formgebung eingeschränkt.

Weiter gab es Versuche, Keramiksubstrate aus reinem Aluminiumoxid (Al₂O₃) mittels eines additiven laserbasierten Prozesses zu strukturieren und anschließend zu metallisieren [AiF, Abschlussbericht IGF-Vorhaben 488ZN]. Die selektive Aktivierung der Oberfläche des Trägersubstrates erfolgte hierbei durch die Reduktion des Aluminium(III)-Oxides zu metallischen Aluminium mittels der in das Material eingekoppelten Laserenergie. Die so entstandenen Aluminiumatome wirkten katalytisch für die Kupferabscheidung bei der stromlosen Metallisierung. Allerdings ist die Reduktion des Aluminium(III)-Oxides aufgrund der geringen Elektronegativität schwierig. Gleichzeitig wird metallisches Aluminium durch Luftsauerstoff schnell oxidiert und verliert hierdurch seine katalytische Aktivität, was eine anschließende Metallisierung entsprechend erschwert.

So ist beispielsweise aus DE 694 07 499 T2 bekannt, ein gesintertes Aluminiumoxidteil oberflächlich mit einem UV-Lichtstrahl zu bestrahlen, der von einer gepulsten Excimerlaserquelle emittiert wird. Das bestrahlte Teil wird anschließend in eine autokatalytische Lösung eingetaucht, welche Ionen des Metalls enthält, welches gleichmäßig auf die bestrahlten Zonen des Teils niedergeschlagen werden soll. Das metallisierte Teil wird durch Löten oder Glühen in einer gesteuerten InertgasAtmosphäre erwärmt.

Aus DE 10 2012 100 299 A1 ist ein Verfahren bekannt, bei dem auf einem Trägermaterial aufgebrachte Leiterbahnstrukturen durch einwirkende elektromagnetische Strahlung nicht selektiv aktiviert, sondern selektiv mit dem Trägermaterial verbunden werden. Hierzu wird eine Beschichtung auf das Trägermaterial aufgebracht, die anschließend selektiv mit der elektromagnetischen Strahlung bestrahlt wird. Die elektromagnetische Strahlung bewirkt hierbei, dass die in der Beschichtung enthaltenen Wirkstoffpartikel in die Oberfläche des Trägermaterials dispergiert werden.

Aus US 2007/0142530 A1 ist ein Keramiksubstrat bekannt, das als Trägersubstrat für einen Schaltungsträger verwendet wird. Das Keramiksubstrat ist hergestellt aus einem inorganischen Pulver und einem organischen Gießharz. Das inorganische Pulver umfasst dabei 72-98 Gew.-% Aluminiumoxid, 1-12 Gew.-% Kupferoxid, 0,1-3 Gew.-% Titanoxid und 0,25-10 Gew.-% Siliziumoxid. Zur Herstellung von Leiterbahnen wird eine leitfähige Paste auf einen Grünkörper des Keramikmaterials aufgetragen und zusammen mit dem Grünkörper gebrannt.

Aus GB 860,863 A ist ein Verfahren zur Herstellung einer elektrisch halbleitenden Keramik und daraus hergestellter Keramikkörper bekannt. Hierzu wird eine Mischung aus Aluminiumoxid (Al₂O₃), Calciumoxid (CaO), Siliziumoxid (SiO₂), Kupferoxid (Cu₂O) und Eisenoxid (Fe₂O₃) gepresst und gesintert.

Ebenfalls bekannt sind laserstrukturierbare keramische Substrate, die Verbindungen von Cu-Cr-O enthalten. Die Herstellung solcher keramischen Substrate ist jedoch kostenintensiv und aufgrund des enthaltenen Chroms als umweltschädlich einzustufen.

Der Erfindung liegt daher die Aufgabe zugrunde, eine Möglichkeit anzugeben, die eine verbesserte und vereinfachte Herstellung von vielfältig einsetzbaren Schaltungsträgern erlaubt.

Diese Aufgabe wird erfindungsgemäß gelöst durch die Merkmale der Ansprüche 1, 8, 12 und 14. Vorteilhafte Ausgestaltungen der Erfindung sind in den Unteransprüchen und der nachfolgenden Beschreibung dargelegt.

Im Rahmen des erfindungsgemäßen Verfahrens, welches zur Herstellung eines Schaltungsträgers angewandt wird, wird ein Trägersubstrat bereitgestellt, in dessen Oberfläche mittels eines Lasers eine Struktur für einen aufzubringenden Leiter eingebracht wird. Die Struktur wird unter Ausbildung des Schaltungsträgers mit einer den Leiter bildenden metallischen Beschichtung versehen. Als Trägersubstrat wird erfindungsgemäß ein keramischer Werkstoff mit einer Zusammensetzung, umfassend 85 bis 99 Vol.-% Aluminiumoxid (Al₂O₃), sowie 1 bis 15 Vol.-% Kupferoxid (Cu₂O) eingesetzt.

Dank des Einsatzes eines keramischen Werkstoffes mit der angegebenen Zusammensetzung als Trägersubstrat ermöglicht das erfindungsgemäße Verfahren die Generierung keramikbasierter dreidimensionaler Schaltungsträger mittels generativer Fertigungsprozesse. Mit anderen Worten lässt sich dank der erfindungsgemäßen Zusammensetzung des keramischen Werkstoffes das bislang für keramische Materialien nicht (oder lediglich bedingt) geeignete Verfahren der Laserstrukturierung zur einfachen und effektiven Herstellung von dreidimensionalen Schaltungsträgern einsetzen.

Durch die Laserbearbeitung der Oberfläche des Trägersubstrates und den anschließenden Metallisierungsprozess lassen sich auf dem Trägersubstrat, also auf dem mit Cu₂O dotierten Al₂O₃- Keramikträgermaterial elektrisch leitfähige Leiterstrukturen (also Strukturen mit den entsprechend aufgebrachten Leiter) herstellen, die neue chemische Verbindungen mit besonderen Eigenschaften enthalten. Mittels der laserbasierten Strukturierungstechnik wird der keramische Werkstoff zuerst selektiv aktiviert. Anschließend wird die mittels der Laserbearbeitung in die Oberfläche des Trägersubstrates eingebrachte Struktur unter Ausbildung des Schaltungsträgers metallisch beschichtet.

Durch die im Rahmen des erfindungsgemäßen Verfahrens zur Herstellung des Schaltungsträgers eingesetzte Zusammensetzung des keramischen Werkstoffes werden die Laser-Aktivität, die Genauigkeit bei der Einbringung der Strukturen sowie die Metallisierungsqualität erhöht. Da das in der Zusammensetzung enthaltenen Kupfer als Katalysator für die Kupferabscheidung dient, ist die Kupferschichtdicke des mittels des erfindungsgemäßen Verfahrens hergestellten Schaltungsträgers nach der Metallisierung im Vergleich zur konventionellen Laserstrukturierung keramischer Materialien erhöht.

Weiter verbessert werden die Laserstrukturierbarkeit und die Metallisierbarkeit des Trägersubstrates, wenn als Trägersubstrat ein keramischer Werkstoff mit einer Zusammensetzung eingesetzt wird, die vorzugsweise 94 bis 98 Vol.-% Aluminiumoxid (Al₂O₃), sowie 2 bis 6 Vol.-% Kupferoxid (Cu₂O) umfasst.

Insgesamt ergibt die Summe der von der Zusammensetzung des keramischen Werkstoffes umfassten Bestandteile, also die Summe der Anteile an Aluminiumoxid (Al₂O₃) und Kupferoxid (Cu₂O), 100 Vol.-%. In diesen 100 Vol.-% sind selbstverständlich auch übliche (insbesondere geringfügige) Verunreinigungen, beispielsweise abhängig von Reinheit der eingesetzten Edukte und/oder dem jeweiligen zur Herstellung des keramischen Werkstoffes eingesetzten Verfahren mit berücksichtigt. Insbesondere kann der keramische Werkstoff im Rahmen der Erfindung Rückstände eines organischen Bindemittels oder weiterer Additive (z.B. eines Dispergiermittels) als verfahrensbedingte Verunreinigungen enthalten.

Vorteilhafterweise wird das Trägersubstrat durch Sintern bei Temperaturen zwischen 1000°C und 1800°C hergestellt. Besonders von Vorteil ist es im Rahmen der Erfindung, wenn das Trägersubstrat durch Sintern bei Temperaturen zwischen 1100°C und 1300°C hergestellt wird.

Grundlegend für das Verfahren zur Herstellung eines Schaltungsträgers mit einem Trägersubstrat aus einem keramischen Werkstoff mit einer Zusammensetzung, umfassend 85 bis 99 Vol.-% Aluminiumoxid (Al₂O₃), sowie 1 bis 15 Vol.-% Kupferoxid (Cu₂O) und insbesondere 94 bis 98 Vol.-% Aluminiumoxid (Al₂O₃), sowie 2 bis 6 Vol.-% Kupferoxid (Cu₂O) ist die gezielte Parameterauswahl zur Laserstrukturierung. Diese stellt aufgrund der Vielzahl möglicher Einstellungsparameter für den Strukturierungsprozess eine besondere Herausforderung dar.

Zur Laserbehandlung eines Werkstückes und im Rahmen der Erfindung insbesondere zur gezielten Strukturierung der Oberfläche des Trägersubstrats (Einbringen von Strukturen als diskrete geometrische Strukturen) werden Laser mit einer speziellen Wellenlänge des emittierendes Lichtes und einer sehr geringen Leistung benötigt. Die Laserwellenlänge zur Strukturierung der Oberfläche des Lasersubstrates liegt vorzugsweise bei 1064nm. Hierzu wird zweckmäßigerweise ein Lasertyp: Nd:YAg eingesetzt.

Unter einer Struktur für einen aufzubringenden Leiter wird im Rahmen der Erfindung grundsätzlich jede zur Herstellung eines entsprechenden Schaltungsträgers in die Oberfläche eines Trägersubstrates eingebrachte Struktur bzw. jedes Oberflächenprofil verstanden. Hiervon sind insbesondere sowohl linienförmige als auch flächige Strukturen umfasst. Selbstverständlich sind die Strukturen jedoch nicht auf diese Ausführungen beschränkt, sondern insbesondere an die Anforderungen des Schaltungsträgers angepasst bzw. auf dessen vorgesehenes Einsatzgebiet abgestimmt.

Die Strukturen werden vorzugsweise mit einer Laserleistung in einem Bereich zwischen 4 Watt und 12 Watt in die Oberfläche des Trägersubstrates eingebracht. Die bevorzugte Lasergeschwindigkeit liegt in einem Bereich zwischen 0,75 m/s bis 2,25 m/s. Die Laserpulsfrequenz, mit welcher die Strukturen in die Oberfläche des Trägersubstrates eingebracht werden, liegt vorzugsweise in einem Bereich zwischen 60 kHz bis 120 kHz.

Besonders bevorzugt ist der Einsatz eines keramischen Werkstoffes als Trägersubstrat mit einer Zusammensetzung, umfassend 95 Vol.-% Al₂O₃ und 5 Vol.-% Cu₂O. Zur Herstellung eines Schaltungsträgers mit einem derart zusammengesetzten Trägersubstrat erfolgt die Laserstrukturierung der Oberfläche vorzugsweise mit einer Laserleistung von 4 Watt, einer Lasergeschwindigkeit von 1,5 m/s und einer Laserfrequenz von 120 kHz.

Zweckmäßigerweise wird die in die Oberfläche des Trägersubstrates eingebrachte Struktur bzw. das jeweilige Profil mit einer Cu-Ni-Au enthaltenden metallische Beschichtung versehen. Die Beschichtung erfolgt vorzugsweise durch eine chemisch außenstromlose Metallisierungsmethode. Hierbei werden - unter Ausbildung des Schaltungsträgers - nacheinander Kupfer, Nickel und Gold stromlos auf die Oberflächenstruktur des Trägersubstrats aufgebracht. Bei der Beschichtung werden Standard-Schichtdicken erreicht. Die Qualität und die Beständigkeit der Metallisierung sind insbesondere im Hinblick auf die Oberflächenrauigkeit, die Haftung der Metallisierung und der Haltbarkeit hervorragend.

Bei einem keramischen Werkstoff mit einer Zusammensetzung, umfassend 95 Vol.-% Al₂O₃ und 5 Vol.-% Cu₂O, dessen Oberfläche wie vorstehend beschrieben strukturiert wurde (Laserleistung 4 Watt, Lasergeschwindigkeit 1,5 m/s und Laserfrequenz von 120 kHz) haben beispielsweise die so erzeugten Kupferleiterbahnen (also linienförmige Strukturen) einen Durchmesser von 160 µm. Der kleinste Abstand zwischen zwei Leiterbahnen liegt bei 20 µm. Die Schichtdicke liegt nach der Metallisierung im Bereich von 8,2 µm bis 12,2 µm. Die Rauheit der Oberfläche nach der Lasereinwirkung liegt im Bereich zwischen 21 µm und 36 µm.

Die Metallisierung stellt sehr hohe Anforderungen an die hierzu eingesetzten Substanzen und den physikalischen Zustand der Lösungen. Im Folgenden ist in einer bevorzugten Ausgestaltung eine Variante einer stromlosen Metallisierung detailliert beschrieben. Der erste Schritt bei der stromlosen Metallisierung stellt die Reinigung mittels Ultraschall in vollentionisiertem Wasser dar. Die Reinigung erfolgt bei einer Temperatur von 293 K und einer Einwirkdauer von mindestens 5 min. Anschließend wird mit vollentionisiertem Wasser gespült. Zur selektiven Kupferabscheidung wird das jeweilige Bauteil, also das Trägersubstrat vollständig in eine Verkupferungslösung getaucht. Die Verkupferungslösung besteht zu je 15 Vol% bis 40 Vol% aus Kupfer(II)-Sulfat CuSO₄ und Formaldehyd COH₂ und wird mit Natronlauge NaOH auf einem pH-Wert von: 11 -13, eingestellt. Das Bad weist eine Temperatur in einem Bereich zwischen 318 K und 333K auf. Zur besseren Umspülung des entsprechenden Bauteils wird trockene, entölte Atmosphärenluft bei Raumtemperatur mit einem Volumenstrom von 1 l/min bei einem Druck von 1200 hPa ausgehend von der Unterseite des Bades in dieses eingeblasen. Der Schichtaufbau des Kupfers erfolgt mit einer Rate von 2 µm/h bis 5 µm/h.

Nach der Kupferabscheidung erfolgt eine gründliche mehrstufige Reinigung des Bauteils in vollentionisiertem Wasser bei einer Temperatur von 293K. Anschließend wird das Bauteil für 30 s bis 60 Sekunden in eine wässrige, starksaure Palladiumsulfat-Lösung eingetaucht und anschließend gespült. Das auf diese Weise behandelte Bauteil wird für die Nickelabscheidung in eine saure Nickel(I)-Phosphatlösung getaucht. Die Nickelabscheidung erfolgt mit einer Rate von 4 µm/h bis 6 µm/h Nickel bei einer Badtemperatur zwischen 348 K und 363 K. Nach ca. 90 min wird das Bauteil aus dem Nickelbad entnommen und erneut mit vollentionisiertem Wasser gewaschen. Abschließend erfolgt die Aufbringung der Goldschicht mit ca. 0,04 µm Gold, einem sogenannten Goldflash, durch das Eintauchen des Bauteils in eine saure Goldcyanid-Lösung für einen Zeitraum von 5 min bis 15 min. Zum Schluss wird das Bauteil noch final mit vollentionisiertem Wasser gewaschen. Durch das Abscheiden der Metallionen an das Bauteil werden die jeweiligen Substanzen bzw. Stoffe aus den Lösungen entfernt und müssen während des Prozesses zudosiert werden.

Keramische Substrate in der Leiterplattentechnik werden häufig in der Leistungselektronik eingesetzt. Hierzu sind Kupferschichten bis zu 200 µm notwendig, damit hohe Ströme transportiert werden können. Zur Verstärkung der Strukturen auf den neuartig strukturierten Schaltungsträgern ist insbesondere die galvanische Metallisierung bevorzugt. Dabei werden die bereits stromlos erzeugten Strukturen mit einer Klemme ankontaktiert (Kathode) und in eine schwefelsaure CuSO₄-Lösung eingetaucht. In der Lösung befindet sich eine Cu-Anode. Wird nun eine Gleichspannung zwischen den beiden Elektroden angelegt scheiden sich an den Strukturen Cu (2+)-Ionen nach dem Faraday'schen Gesetz kontinuierlich ab. Mit dieser Methode können definiert vorgegebene Cu-Schichtdicken erzeugt werden.

Das erfindungsgemäße Trägersubstrat für einen Schaltungsträger umfasst einen keramischen Werkstoff mit einer Zusammensetzung, umfassend 85 bis 99 Vol.-% Aluminiumoxid (Al₂O₃), sowie 1 bis 15 Vol.-% Kupferoxid (Cu₂O). Besonders bevorzugt umfasst das Trägersubstrat einen keramischen Werkstoff mit einer Zusammensetzung umfassend 94 bis 98 Vol.-% Aluminiumoxid (Al₂O₃), sowie 2 bis 6 Vol.-% Kupferoxid (Cu₂O).

Das Trägersubstrat ist vorzugweise hergestellt durch Sintern bei Temperaturen zwischen 1000°C und 1800°C. Besonders von Vorteil es, wenn das Trägersubstrat durch Sintern bei Temperaturen zwischen 1100°C und 1300°C hergestellt ist.

Weitere vorteilhafte Ausgestaltungen für das Trägersubstrat ergeben sich aus den auf das Verfahren gerichteten Unteransprüchen. Die hierzu benannten Vorteile können sinngemäß auf das Trägersubstrat übertragen werden.

Erfindungsgemäß wird ein keramischer Werkstoff mit einer Zusammensetzung, umfassend 85 bis 99 Vol.-% Aluminiumoxid (Al₂O₃), sowie 1 bis 15 Vol.-% Kupferoxid (Cu₂O) als Trägersubstrat für einen Schaltungsträger verwendet, wobei das Trägersubstrat insbesondere in dem vorstehend beschriebenen, erfindungsgemäßen Verfahren zur Herstellung eines Schaltungsträgers verwendet wird. Besonders bevorzugt ist die Verwendung eines keramischen Werkstoffes mit einer Zusammensetzung umfassend 94 bis 98 Vol.-% Aluminiumoxid (Al₂O₃), sowie 2 bis 6 Vol.-% Kupferoxid (Cu₂O).als Trägersubstrat für einen Schaltungsträger.

Durch die Verwendung einer erfindungsgemäßen Mischung aus Aluminiumoxid und Kupferoxid, also einer Zusammensetzung von mit Cu₂O dotiertem Al₂O₃ als keramischer Werkstoff für ein Trägersubstrat entsteht nach einer thermischen Behandlung der entsprechenden Mischung, also nach dem Sintern ein neuer Werkstoff. Als Reaktionsprodukte entstehen CuAlO₂ und CuAl₂O₄, wobei sich die Konzentration von CuAl₂O₄ mit steigender Sintertemperatur erhöht. Die Phasen nehmen in dem neuen Werkstoff eine bestimmte Ordnung an, durch welche die Eigenschaften des Materials beeinflusst werden. Eine Weiterverarbeitung eines Werkstückes mit der erfindungsgemäßen Zusammensetzung ist speziell für die Laserdirektstrukturierung besonders gut geeignet.

Der als Trägersubstrat für einen Schaltungsträger eingesetzte keramische Werkstoff ist vorzugsweise durch Sintern bei Temperaturen zwischen 1000°C und 1800°C hergestellt. Besonders bevorzugt ist der als Trägersubstrat für einen Schaltungsträger verwendete keramische Werkstoff durch Sintern bei Temperaturen zwischen 1100°C und 1300°C hergestellt.

Weitere vorteilhafte Ausgestaltungen für die Verwendung des keramischen Werkstoffes ergeben sich aus den auf das Verfahren und auf das Trägersubstrat gerichteten Unteransprüchen. Die hierzu benannten Vorteile können sinngemäß auf die Verwendung übertragen werden.

Der erfindungsgemäße keramische Werkstoff für ein Trägersubstrat eines Schaltungsträgers weist eine Zusammensetzung auf, die 85 bis 99 Vol.-% Aluminiumoxid (Al₂O₃), sowie 1 bis 15 Vol.-% Kupferoxid (Cu₂O) umfasst. Weiter bevorzugt weist der keramische Werkstoff für einen Schaltungsträger eine Zusammensetzung auf, die 94 bis 98 Vol.-% Aluminiumoxid (Al₂O₃), sowie 2 bis 6 Vol.-% Kupferoxid (Cu₂O) umfasst. Die Summe aller von der Zusammensetzung des keramischen Werkstoffes umfassten Bestandteile - inklusive üblicher, geringfügiger Verunreinigungen - ergibt hierbei 100 Vol.-%.

In vorteilhafter Ausgestaltung ist der keramische Werkstoff durch Sintern bei Temperaturen zwischen 1000°C und 1800°C hergestellt. Weiter bevorzugt ist keramischer Werkstoff hergestellt durch Sintern bei Temperatuten zwischen 1100°C und 1300°C.

Weitere vorteilhafte Ausgestaltungen für die Verwendung des keramischen Werkstoffes ergeben sich aus den auf das Verfahren, auf das Trägersubstrat sowie auf die Verwendung gerichteten Unteransprüchen. Die hierzu benannten Vorteile können sinngemäß auf den keramischen Werkstoff übertragen werden.

Nachfolgend werden Ausführungsbeispiele der Erfindung anhand einer Zeichnung näher erläutert. Darin zeigen:
- Fig. 1: eine Auftragung einer Partikelgrößenverteilung der zur Herstellung eines keramischen Werkstoffes eingesetzten Edukte Al₂O₃, Cu₂O und Dextrin,
- Fig. 2: eine Mikroskopieaufnahme (SEM) eines durch Sintern bei 1200 °C hergestellten keramischen Werkstoffes mit einem Verhältnis von Al₂O₃ zu Cu₂O von 95 Vol.-% zu 5 Vol.-%,
- Fig. 3: die Mikroskopieaufnahme gemäß Fig. 2 in 10-facher Vergrößerung,
- Fig. 4: eine weitere Mikroskopieaufnahme (SEM) eines durch Sintern bei 1600 °C hergestellten keramischen Werkstoffes mit einem Verhältnis von Al₂O₃:Cu₂O von 85 Vol.-% zu 15 Vol.-%,
- Fig. 5: die Mikroskopieaufnahme (SEM) gemäß Fig. 4 in 10-facher Vergrößerung,
- Fig. 6: eine XRD-Aufnahme,
- Fig. 7: einen 3D-Mikroskop-Laserscan für den strukturierten Bereich eines Trägersubstrates,
- Fig. 8: einen Ausschnitt eines Trägersubstrats mit einer auf der Oberfläche eingebrachten flächigen Struktur,
- Fig. 9: den Ausschnitt des Trägersubstrats gemäß Fig. 8 mit der metallisierten flächigen Leiterstruktur,
- Fig. 10: einen Ausschnitt eines Trägersubstrats mit einer auf der Oberfläche eingebrachten linienförmigen Struktur, sowie
- Fig. 11: den Ausschnitt des Trägersubstrats gemäß Fig. 10 mit der metallisierten linienförmigen Leiterstruktur.

Einander entsprechende Teile und Größen sind in allen Figuren stets mit gleichen Bezugszeichen versehen.

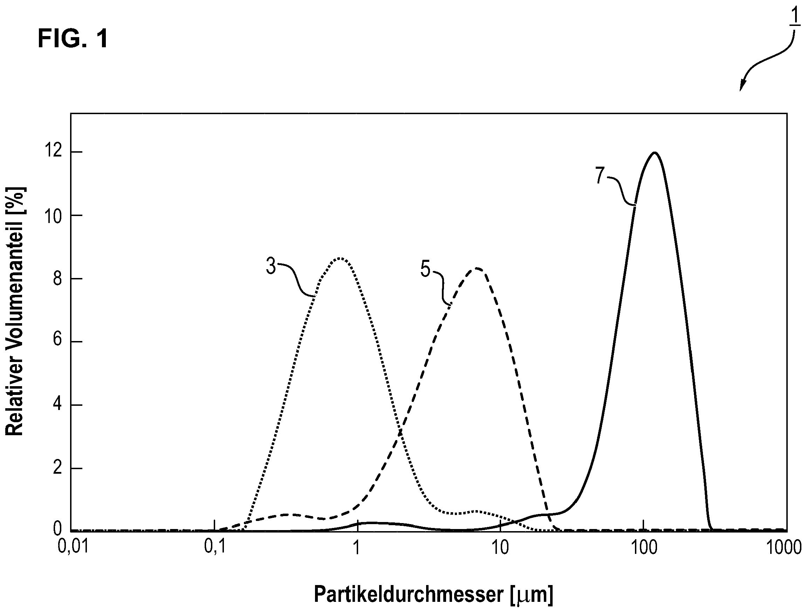

Fig. 1 zeigt die Partikelgrößenverteilung der zur Herstellung eines erfindungsgemäßen Trägersubstrates eingesetzten Partikel-Mischung (also der eingesetzten Edukte Al₂O₃, Cu₂O und Dextrin) in einer Auftragung 1 des Partikeldurchmessers [µm] gegen den relativen Volumenanteil [%] der Edukte in der Mischung.

Als Edukte wurden Submikron-Al₂O₃-Pulver (Kurve 3) (CT 3000 SG, Almatis GmbH, Ludwigshafen, Deutschland), Cu₂O-Pulver (Kurve 5) (Strem Chemicals, Inc., KEHL, Deutschland) und Dextrin-Bindemittel (C₆H₁₀O₅)ₙ (Kurve 7) (Superior Gelbmittel F, Suedstaerke, Schrobenhausen, Deutschland, n = 10 - 200, d₅₀ = 109 µm, Molekulargewicht 1600 - 32000 g/Mol) eingesetzt. Die drei Edukte Al₂O₃, Cu₂O und Dextrin wurden in entionisiertem Wasser durch Zugabe einer Darvan C-N Dispergiermittel Lösung (Electrosteric Dispergiermittel Ammoniumsalz der Polymethacrylic Säure, r.t. Vanderbilt Co. Inc. Norwalk, CT, USA) dispergiert.

In Tabelle 1 sind die die spezifischen Eigenschaften der zur Herstellung eines keramischen Werkstoffes eingesetzten Edukte aufgeführt.

**Tabelle 1: Eigenschaften der eingesetzten Edukte Al₂O₃, Cu₂O und Dextrin**

| | | **Al₂O₃** | **Dextrin** | **Cu₂O** |
|---|---|---|---|---|
| Spezifische Oberfläche [m²/g] | | 9.3 | 0.1 | 2,1 |
| | *d*₉₀ | 2.0 | 194.8 | 12.5 |
| Partikelgröße [µm] | *d*₅₀ | 0.8 | 109.0 | 5.5 |
| | *d*₁₀ | 0.3 | 50.8 | 1.7 |

Die Bindemittel-gestützte wässrige Al₂O₃-Cu₂O-Suspension wurde in einem Taumel-Mischer (Turbula^{®}, Willy A. Bachofen AG, Schweiz) mit Al₂O₃-Schleifkugeln über einen Zeitraum von 24 h homogenisiert und anschließend bei einem Druck von 0,38 mPa gefriergetrocknet (Delta 2-24, Christ, Osterode/Harz, Deutschland). Da aufgrund des Fehlens von Kapillarkräften keine Schrumpfung während der Gefriertrocknung beobachtet werden kann, ist die mechanische Festigkeit und Porosität der erhaltenen gefriergetrockneten Rohlinge (Chargen) abhängig vom Gehalt des Lösungsmittels (Wasser) in dem resultierenden keramischen Schlamm.

Nach der Gefriertrocknung wurden die getrockneten Chargen für weitere 24 Stunden gemahlen und durch ein Sieb mit einer Maschenweite von 150 µm gesiebt. Die Aluminiumoxid (Al₂O₃)- und die Kupferoxid (Cu₂O)-Partikel sind nach der Verschlämmung, der Gefriertrocknung und dem Vermahlen homogen verteilt und weisen eine Dextrin-Schicht auf, so dass der weitere Formgebungsprozess auch zur Herstellung von Keramik-Grünlingen mit relativ hoher mechanischer Festigkeit genutzt werden kann.

Da die Cu₂O-Konzentration in der zur Herstellung des keramischen Werkstoffes eingesetzten Mischung eine wichtige Rolle für die endgültigen Materialeigenschaften, wie insbesondere die Laser-Aktivierbarkeit und die Dichte des keramischen Werkstoffes nach der thermischen Behandlung spielt, wurden die Volumenverhältnisse von Al₂O₃ und Cu₂O variiert.

Hierzu wurden die gemahlenen und gesiebten Pulver in verschiedene Volumenverhältnissen vermischt und anschließend einachsig bei einem Druck von 200 MPa in eine zylindrische Form mit einem Durchmesser von 40 mm und einer Dicke von 2 mm bis 5 mm gepresst (Paul Weber, Maschinen Und Apparatebau, Stuttgart, Deutschland). Anschließend wurden die Bindemittel-gestützten Cu₂O-Al₂O₃-Formteile in Luft bei Temperaturen von 1200 °C, 1400 °C und 1600 °C für 1 Stunde gesintert.

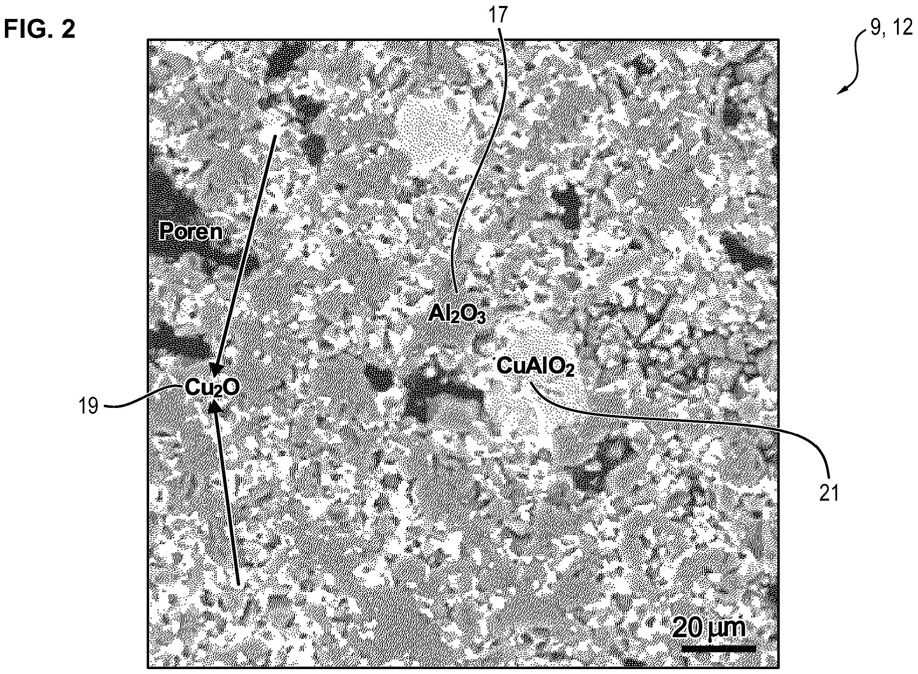

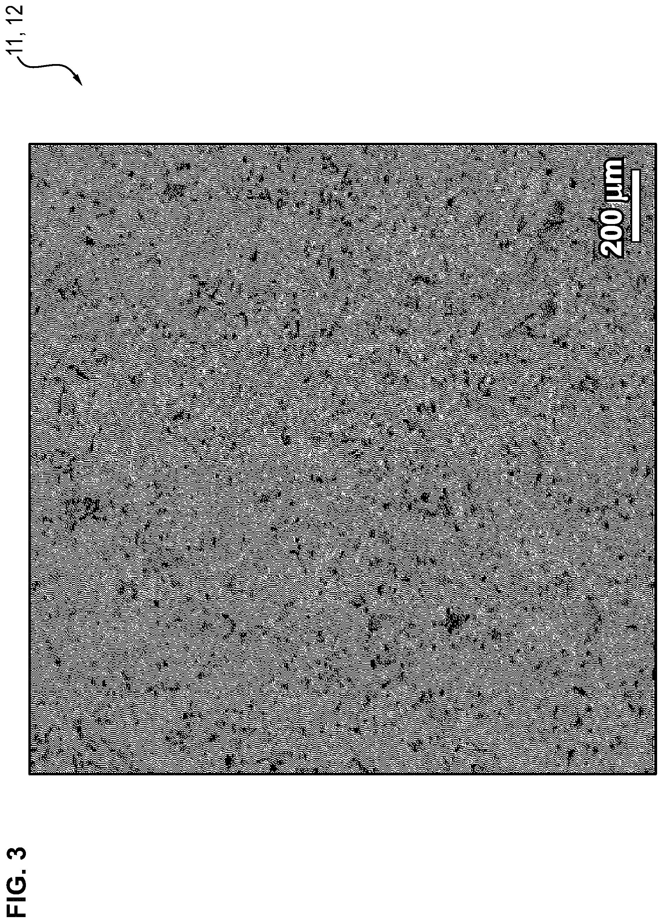

Die Mikrostrukturen (ermittelt durch EDX-Analyse) von zwei Proben mit unterschiedlichen Cu₂O-Al₂O₃- Konzentrationen in den eingesetzten Pulver- Mischungen nach dem Sintern bei unterschiedlichen Temperaturen sind in den Fig. 2 bis 5 gezeigt. In den Fig. 2 und 3 sind Mikroskopieaufnahmen 9, 11 eines durch Sintern bei 1200 °C hergestellten keramischen Werkstoffes 12 mit einem Verhältnis von Al₂O₃ zu Cu₂O von 95 Vol.-% zu 5 Vol.-% mit einer Auflösung von 200 µm (Fig. 2), sowie mit einer Auflösung von 20 µm (Fig. 3) gezeigt.

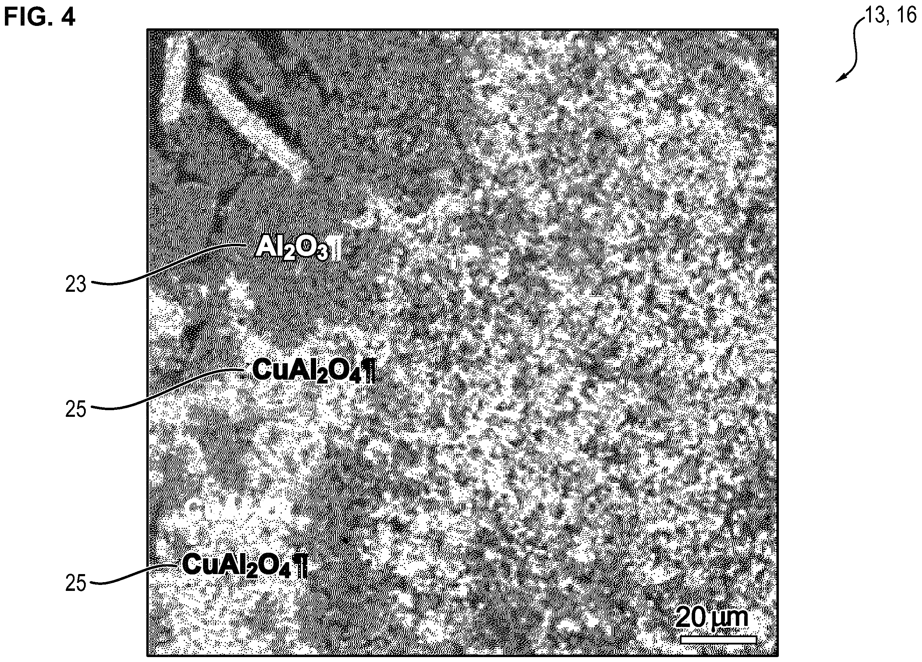

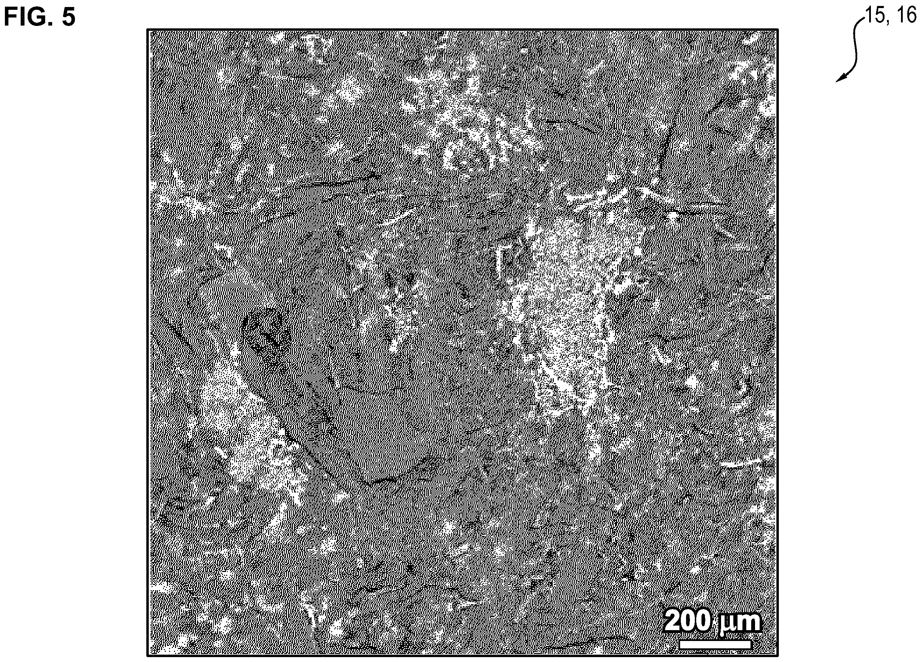

Die Fig. 4 und 5 zeigen jeweils Mikroskopieaufnahmen13, 15 eines durch Sintern bei 1600 °C hergestellten keramischen Werkstoffes mit einem Verhältnis von Al₂O₃ zu Cu₂O von 85 Vol.-% zu 15 Vol.-% mit einer Auflösung von 200 µm (Fig. 4), sowie mit einer Auflösung von 20 µm (Fig. 5).

Anhand der Mikroskopieaufnahme 9 (Fig. 2) ist zu erkennen, dass bei einer Temperatur von 1200 °C gesinterte Proben drei verschiedene Phasen entstehen: eine Al₂O₃-Phase 17, eine Cu₂O-Phase 19 und eine CuAlO₂-Phase 21, die in-situ durch die Reaktion zwischen Al₂O₃ und Cu₂O gebildet wurde. Die Porosität nach dem Sintern bei 1200 °C liegt bei etwa ~ 45 %.

Im Unterschied hierzu weist der keramische Werkstoff 16, der bei 1600 ° C gesintert wurde, eine dichtere Mikrostruktur mit einer Restporosität von nur ~ 3 % auf (Fig. 4, Mikroskopieaufnahme 13). Außerdem konnten bei Proben, die bei einer Temperatur von 1600 °C gesintert wurden, lediglich zwei verschiedene Phasen beobachtet werden, nämlich eine Al₂O₃-Phase 23 und eine CuAl₂O₄-Phase 25. Eine Cu₂O-Phase ist aufgrund der vollständigen Abreaktion von Cu₂O bei höheren Temperaturen nicht mehr vorhanden. Aufgrund von heterogenem in-situ- Wachstum von Kupfer Aluminiumoxid Spinellen zeigt die CuAl₂O₄-Phase 25 sowohl nadelförmige als auch unregelmäßige Formen. Durch die Oxidation von Cu⁺ (Cu₂O) zu Cu²⁺ (CuAl₂O₄) ändert sich die Farbe der Proben nach dem Sintern bei 1600 °C von gelb nach dunkelrot. Gleichzeitig erhöht sich die mechanische Stabilität mit Erhöhung der Sintertemperatur aufgrund der stärkeren Verdichtung.

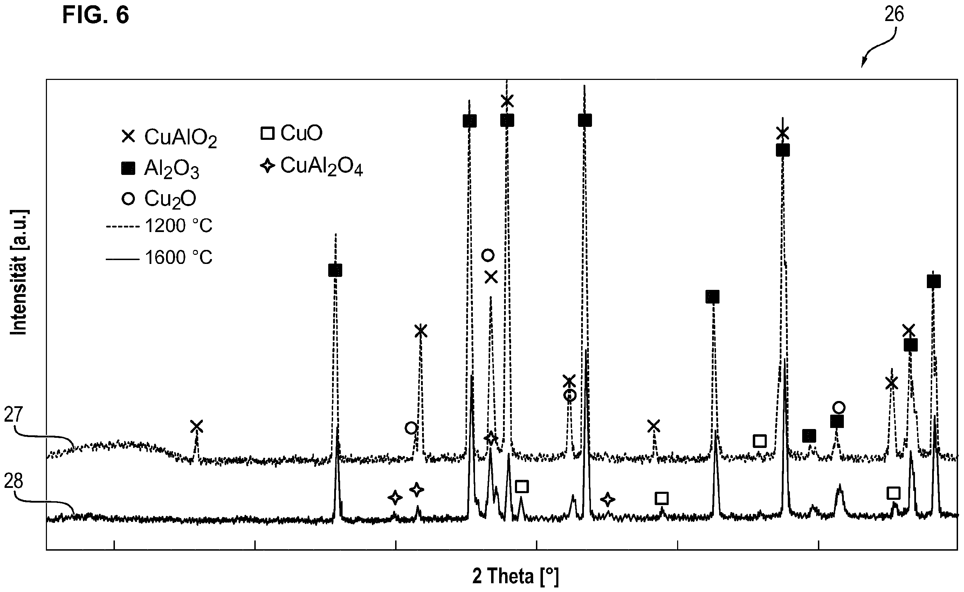

Mit zunehmender Cu₂O-Konzentration in den eingesetzten Pulver-Mischungen (vor der Sinterung) lässt sich die CuAl₂O₄-Phase 25 in den gesinterten Produkten anreichern. Die anhand der EDX-Analysen erhaltenen Ergebnisse wurden weiter mittels XRD-Analysen (Röntgendiffraktion) bestätigt. Eine solche XRD-Analyse ist in Auftragung 26 ist in Fig. 6 gezeigt. Die Auftragung 26 zeigt eine Kurve 27 für eine Probe mit 85 Vol.-% Al₂O₃ und 15 Vol.-% Cu₂O, die bei einer Temperatur von 1200 °C gesintert wurde, sowie eine Kurve 28 für eine Probe mit 85 Vol.-% Al₂O₃ und 15 Vol.-% Cu₂O, die bei einer Temperatur von 1600 °C gesintert wurde.

Bei einer Sintertemperatur von 1200 °C (Kurve 27) können CuO und CuAlO₂ gemäß folgender Reaktionen gebildet werden:
2 Cu₂O + O₂(g) → 4 CuO
Cu₂O + Al₂O₃ → 2 CuAlO₂ (mit Cu +1, Al +3 und O -2)

Bei einer Sintertemperatur von 1600 °C (Kurve 28) können CuO und CuAlO₂ gemäß folgender Reaktionen gebildet werden:
2 Cu₂O + 4 Al₂O₃ + O₂ (g) → 4 CuAl₂O₄ (mit Cu +2, Al +3 und O -2)
4 CuAlO₂ + O₂(g) → 2 CuAl₂O₄ + 2 CuO

Nach dem Sintern bei einer Temperatur von 1200 °C ist Cu⁺¹ (z.B. in Cu₂O und CuAlO₂ - in Auftragung 26 gekennzeichnet durch Kreissymbole (Cu₂O) und Kreuze (CuAlO₂)) noch vorhanden, während Cu⁺¹ nach dem Sintern bei 1600 °C zu Cu⁺² oxidiert wird (CuO und CuAl₂O₄- in Auftragung 26 gekennzeichnet durch ungefüllte Quadrate (CuO) und Sternsymbole (CuAl₂O₄)).

Nach der Herstellung der keramischen Substrate wurde deren Eignung für die Laserstrukturierung und entsprechend für MID-Anwendungen untersucht. Hierzu wurden Experimente basierend auf statistischer Versuchsplanung (DoE, Design of Experiments) durchgeführt. Untersucht wurden insbesondere die Wirkung der Strukturierungsparameter (LDS-Parameter) wie die Laserleistung, die Laserfrequenz und die Strukturierungsgeschwindigkeit, sowie (als Fertigungsparameter) der Anteil der additiven Cu₂O-Teilchen und die Kerntemperaturen der Proben.

Mittels eines Lasers wurden verschiedene Strukturen in die Oberflächen der hergestellten Substrate eingebracht, um die Eignung des jeweiligen Substrates (und damit des jeweiligen neuen Materials) für die Herstellung normaler und Mikro-MID-Produkte zu überprüfen. Hierzu wurde nach der Laserstrukturierung eine Reihe von Messungen zur Prüfung der Auswirkungen des Strukturierungsprozesses auf die Substratoberfläche durchgeführt. Besonderes Augenmerk wurde auf die Aktivierbarkeit der Oberfläche und die Eigenschaften des strukturierten Bereichs gelegt. Die Strukturierung erfolgte mit einer Laserleistung in einem Bereich zwischen 4 Watt und 12 Watt, einer Lasergeschwindigkeit in einem Bereich zwischen 0,75 m/s bis 2,25 m/s und einer Laserfrequenz in einem Bereich zwischen 60 kHz bis 120 kHz.

Nach der Untersuchung von Mischungsvariationen zeigt sich ein Trend zu weniger Cu₂O-Anteil (Fig. 2 und 3). Besonders gute Resultate wurden bei einer Temperatur von 1200 °C gesinterten keramischen Werkstoffen aus 95 Vol.-% Al₂O₃ und 5 Vol.-% Cu₂O nach dem Sintern bei 1200°C erzielt. Für einen solchen keramischen Werkstoff sind die optimalen Parameter bei der Laserstrukturierung eine Laserleistung von 4 Watt, eine Lasergeschwindigkeit von1,5 m/s und eine Laserpulsfrequenz von 120 kHz.

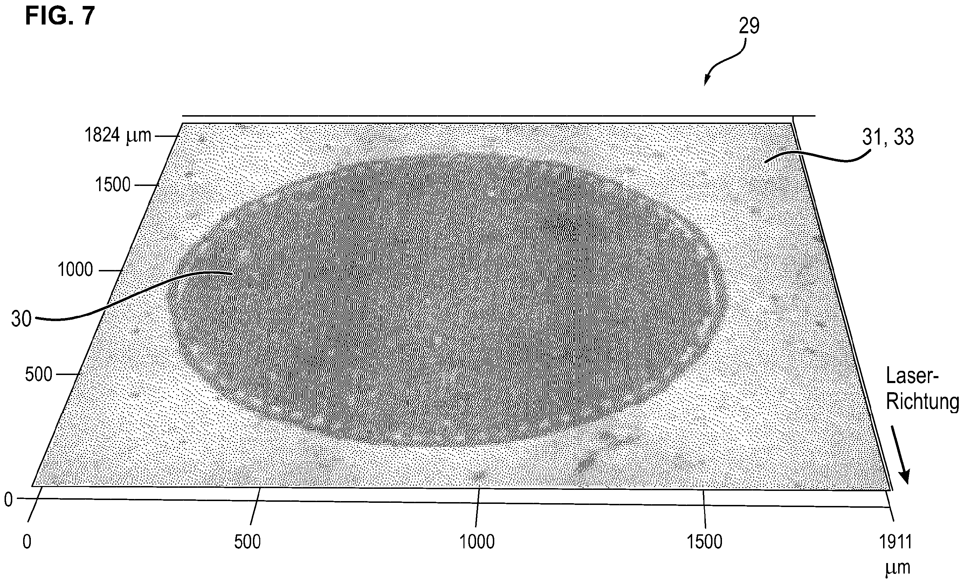

Darüber hinaus zeigen die erfindungsgemäßen keramischen Werkstoffe bzw. die aus diesen hergestellten Trägersubstrate im Unterschied zu Standard-Polymermaterialien, die häufig Strukturierungsdefekte aufweisen, hervorragende Eigenschaften sowohl in gefurchten Bereichen als auch in strukturierten Bereichen. Fig. 7 zeigt einen repräsentativen 3D-Mikroskop-Laserscan 29 für einen flächig strukturierten Bereich 30 auf der Oberfläche 31 eines durch Sintern bei 1200 °C hergestellten Trägersubstrates 33. Das Verhältnis von Al₂O₃ zu Cu₂O liegt bei 95 Vol.-% zu 5 Vol.-%.

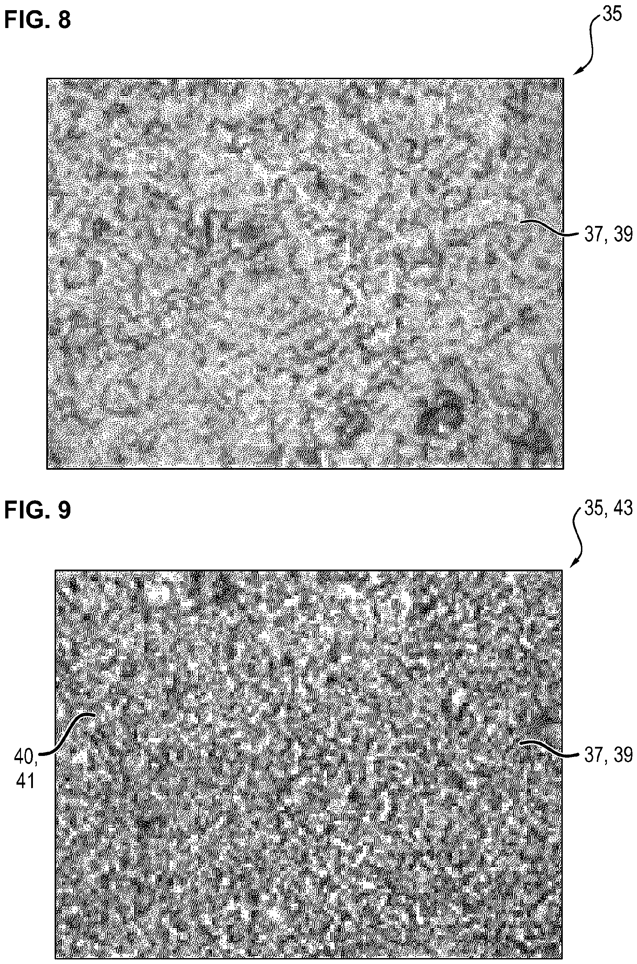

Fig. 8 zeigt einen Ausschnitt eines laserstrukturierten eines durch Sintern bei 1200 °C hergestellten Trägersubstrates 35 mit einer flächigen Struktur 37 auf der Oberfläche 39 des Trägersubstrates 35. Das Verhältnis von Al₂O₃ zu Cu₂O liegt auch hier bei 95 Vol.-% zu 5 Vol.-%. In Fig. 9 ist der gleiche Ausschnitt des laserstrukturierten Trägersubstrates 35 gezeigt. In Fig. 9 ist die flächige Struktur 37 des Trägersubstrats 35 allerdings schon mit einer den Leiter 40 bildenden Cu/Ni/Au-Beschichtung 41 versehen und lässt sich somit als Schaltungsträger 43 einsetzen.

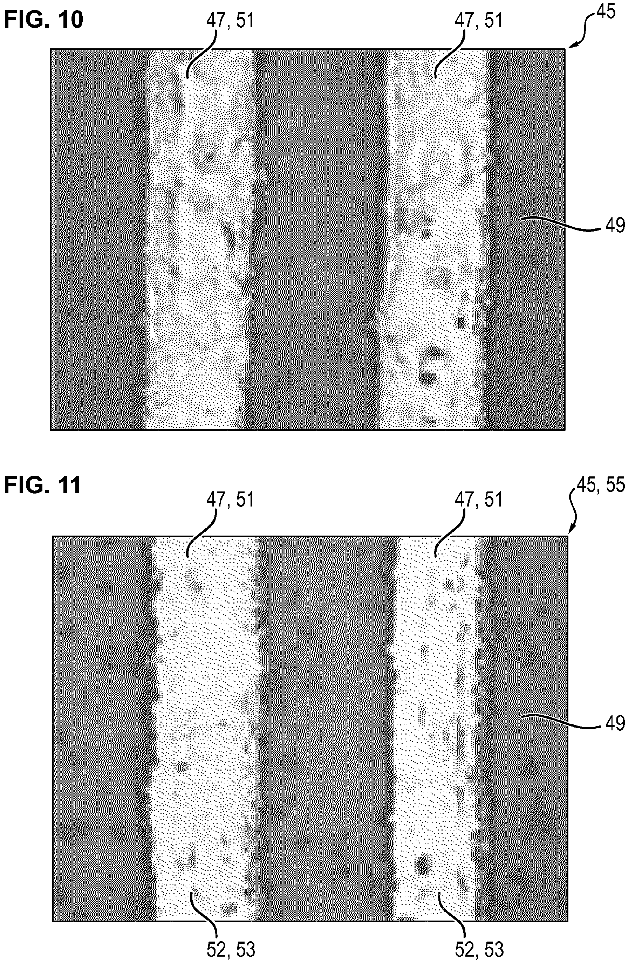

Fig. 10 zeigt ebenfalls einen Ausschnitt eines bei 1200 °C gesinterten laserstrukturierten Trägersubstrates 45. Wie auch bei den Trägersubstraten 33, 35 (Fig. 7 bis 9) und dem Trägersubstraten liegt das Verhältnis von Al₂O₃ zu Cu₂O bei 95 Vol.-% zu 5 Vol.-%. Das Trägersubstrat 45 weist eine linienförmige Struktur 47 auf der Oberfläche 49 des Trägersubstrates 45 auf. Zu erkennen sind zwei einander benachbarte Bahnen 51. Fig. 11 den Ausschnitt des laserstrukturierten Trägersubstrates 45 gemäß Fig. 10. Vorliegend sind die Bahnen 51 (analog zur flächigen Struktur 37 gemäß Fig. 9) mit einer den Leiter 52 bildenden einer Cu/Ni/Au-Beschichtung 53 versehen, so dass auch das Trägersubstrat 45 als Schaltungsträger 55 eingesetzt werden kann.

Die Erfindung wird an den vorstehend beschriebenen Ausführungsbeispielen besonders deutlich, ist auf diese Ausführungsbeispiele gleichwohl aber nicht beschränkt. Vielmehr können weitere Ausführungsformen der Erfindung aus den Ansprüchen und der vorstehenden Beschreibung abgeleitet werden.

### Bezugszeichenliste

- 1: Auftragung Partikelgrößenverteilung
- 3: Kurve Al₂O₃
- 5: Kurve Cu₂O
- 7: Kurve Dextrin
- 9: SEM-Mikroskopieaufnahme
- 11: SEM-Mikroskopieaufnahme
- 12: keramischer Werkstoff
- 13: SEM-Mikroskopieaufnahme
- 15: SEM-Mikroskopieaufnahme
- 16: keramischer Werkstoff
- 17: Al₂O₃-Phase
- 19: Cu₂O-Phase
- 21: CuAlO₂-Phase
- 23: Al₂O₃-Phase
- 25: CuAl₂O₄-Phase
- 26: Auftragung XRD-Analyse
- 27: Kurve (Sintertemperatur T = 1200 °C)
- 28: Kurve (Sintertemperatur T = 1200 °C)
- 29: 3D-Mikroskopie Laserscan
- 30: strukturierter Bereich
- 31: Oberfläche Trägersubstrat
- 33: Trägersubstrat
- 35: Trägersubstrat
- 37: Struktur
- 39: Oberfläche Trägersubstrat
- 40: Leiter
- 41: Beschichtung / Metallisierung
- 43: Schaltungsträger
- 45: Trägersubstrat
- 47: Struktur
- 49: Oberfläche Trägersubstrat
- 51: Bahn
- 52: Leiter
- 55: Beschichtung / Metallisierung
- 55: Schaltungsträger

## Patentansprüche

1. Verfahren zur Herstellung eines Schaltungsträgers (43, 55), wobei ein Trägersubstrat (33, 35, 45) bereitgestellt wird, wobei mittels eines Lasers eine Struktur (37, 47) für einen aufzubringenden Leiter (40, 52) in die Oberfläche (31, 39, 39) des Trägersubstrates (33, 35, 45) eingebracht wird, wobei die Struktur (37, 47) unter Ausbildung des Schaltungsträgers (43, 54) mit einer den Leiter (40, 52) bildenden metallischen Beschichtung (41, 53) versehen wird, und wobei als Trägersubstrat (33, 35, 45) ein keramischer Werkstoff (12, 16) eingesetzt wird,
**dadurch gekennzeichnet,**
**dass** der keramische Werkstoff eine Zusammensetzung, umfassend 85 bis 99 Vol.-% Aluminiumoxid, Al₂O₃, sowie 1 bis 15 Vol.-% Kupferoxid, Cu₂O, aufweist.

2. Verfahren nach Anspruch 1, wobei als Trägersubstrat (33, 35, 45) ein keramischer Werkstoff (12, 16) mit einer Zusammensetzung, umfassend 94 bis 98 Vol.-% Aluminiumoxid, Al₂O₃, sowie 2 bis 6 Vol.-% Kupferoxid, Cu₂O, eingesetzt wird.

3. Verfahren nach Anspruch 1 oder 2, wobei das Trägersubstrat (33, 35, 45) durch Sintern bei Temperaturen zwischen 1000°C und 1800°C hergestellt wird.

4. Verfahren nach einem der vorhergehenden Ansprüche, wobei das Trägersubstrat (33, 35, 45) durch Sintern bei Temperaturen zwischen 1100°C und 1300°C hergestellt wird.

5. Verfahren nach einem der vorhergehenden Ansprüche, wobei die Leiterstruktur (37, 47) mit einer Laserleistung in einem Bereich zwischen 4 Watt und 12 Watt in die Oberfläche (31, 39, 39) des Trägersubstrates (33, 35, 45) eingebracht wird.

6. Verfahren nach einem der vorhergehenden Ansprüche, wobei die Leiterstruktur (37, 47) mit einer Lasergeschwindigkeit in einem Bereich zwischen 0,75 m/s bis 2,25 m/s in die Oberfläche (31, 39, 39) des Trägersubstrates (33, 35, 45) eingebracht wird.

7. Verfahren nach einem der vorhergehenden Ansprüche, wobei die Leiterstruktur (37, 47) mit einer Laserpulsfrequenz in einem Bereich zwischen 60 kHz bis 120 kHz in die Oberfläche (31, 39, 39) des Trägersubstrates (33, 35, 45) eingebracht wird.

8. Trägersubstrat (33, 35, 45) für einen Schaltungsträger (43, 55), umfassend einen keramischen Werkstoff (12, 16) mit einer Zusammensetzung, umfassend 85 bis 99 Vol.-% Aluminiumoxid, Al₂O₃, sowie 1 bis 15 Vol.-% Kupferoxid, Cu₂O,
**dadurch gekennzeichnet,**
**dass** sich die Anteile an Aluminiumoxid, Al₂O₃, und Kupferoxid, Cu₂O, unter Berücksichtigung üblicher Verunreinigungen zu 100 Vol.-% ergänzen.

9. Trägersubstrat (33, 35, 45) nach Anspruch 8, umfassend einen keramischen Werkstoff (12, 16) mit einer Zusammensetzung umfassend 94 bis 98 Vol.-% Aluminiumoxid, Al₂O₃, sowie 2 bis 6 Vol.-% Kupferoxid, Cu₂O.

10. Trägersubstrat (33, 35, 45) nach Anspruch 8 oder 9, hergestellt durch Sintern bei Temperaturen zwischen 1000°C und 1800°C.

11. Trägersubstrat (33, 35, 45) nach einem der Ansprüche 8 bis 10, hergestellt durch Sintern bei Temperaturen zwischen 1100°C und 1300°C.

12. Verwendung eines keramischen Werkstoffes (12, 16) mit einer Zusammensetzung, umfassend 85 bis 99 Vol.-% Aluminiumoxid, Al₂O₃, sowie 1 bis 15 Vol.-% Kupferoxid, Cu₂O, als Trägersubstrat (33, 35, 45), für einen Schaltungsträger (43, 55),
**dadurch kennzeichnet,**
**dass** sich die Anteile an Aluminiumoxid, Al₂O₃, und Kupferoxid, Cu₂O, unter Berücksichtigung üblicher Verunreinigungen zu 100 Vol.-% ergänzen.

13. Verwendung eines keramischen Werkstoffes (12, 16) nach Anspruch 12 mit einer Zusammensetzung, umfassend 94 bis 98 Vol.-% Aluminiumoxid, Al₂O₃, sowie 2 bis 6 Vol.-% Kupferoxid, Cu₂O.

14. Keramischer Werkstoff (12, 16) für ein Trägersubstrat (33, 35, 45) eines Schaltungsträgers (43, 55) mit einer Zusammensetzung, umfassend 85 bis 99 Vol.-% Aluminiumoxid, Al₂O₃, sowie 1 bis 15 Vol.-% Kupferoxid, Cu₂O,
**dadurch gekennzeichnet,**
**dass** sich die Anteile an Aluminiumoxid, Al₂O₃, und Kupferoxid, Cu₂O, unter Berücksichtigung üblicher Verunreinigungen zu 100 Vol.-% ergänzen.

15. Keramischer Werkstoff (12, 16) nach Anspruch 14, umfassend 94 bis 98 Vol.-% Aluminiumoxid, Al₂O₃, sowie 2 bis 6 Vol.-% Kupferoxid, Cu₂O.

16. Keramischer Werkstoff (12, 16) nach Anspruch 14 oder 15, hergestellt durch Sintern bei Temperaturen zwischen 1000°C und 1800°C.

17. Keramischer Werkstoff nach einem der Ansprüche 14 bis 16, hergestellt durch Sintern bei Temperatuten zwischen 1100°C und 1300°C.

## Claims

1. Method for producing a circuit carrier (43, 55), wherein a carrier substrate (33, 35, 45) is provided, wherein a structure (37, 47) for a conductor (40, 52) to be applied is introduced by means of a laser into the surface (31, 39, 39) of the carrier substrate (33, 35, 45), wherein the structure (37, 47) is provided with a metallic coating (41, 53) forming the conductor (40, 52) under formation of the circuit carrier (43, 54), and a ceramic material (12, 16) is used as the carrier substrate (33, 35, 45),
**characterized in**
**that** the ceramic material has a composition comprising 85 to 99 vol-% aluminum oxide, Al₂O₃, and 1 to 15 vol-% copper oxide, Cu₂O.

2. Method according to claim 1, wherein as carrier substrate (33, 35, 45) a ceramic material (12, 16) with a composition comprising 94 to 98 vol-% aluminum oxide, Al₂O₃, and 2 to 6 vol-% copper oxide, Cu₂O, is used.

3. Method according to claim 1 or 2, wherein the carrier substrate (33, 35, 45) is produced by sintering at temperatures between 1000°C and 1800°C.

4. Method according to one of the preceding claims, wherein the carrier substrate (33, 35, 45) is produced by sintering at temperatures between 1100°C and 1300°C.

5. Method according to one of the preceding claims, wherein the conductor structure (37, 47) is introduced into the surface (31, 39, 39) of the carrier substrate (33, 35, 45) with a laser power in a range between 4 watts and 12 watts.

6. Method according to one of the preceding claims, wherein the conductor structure (37, 47) is introduced into the surface (31, 39, 39) of the carrier substrate (33, 35, 45) at a laser speed in a range between 0.75 m/s to 2.25 m/s.

7. Method according to one of the preceding claims, wherein the conductor structure (37, 47) is introduced into the surface (31, 39, 39) of the carrier substrate (33, 35, 45) with a laser pulse frequency in a range between 60 kHz to 120 kHz.

8. Carrier substrate (33, 35, 45) for a circuit carrier (43, 55) comprising a ceramic material (12, 16) with a composition comprising 85 to 99 vol-% aluminum oxide, Al₂O₃, and 1 to 15 vol-% copper oxide, Cu₂O,
**characterized in**
**that** the proportions of aluminum oxide, Al₂O₃, and copper oxide, Cu₂O, add up to 100% vol-%, taking into account usual impurities.

9. Carrier substrate (33, 35, 45) according to claim 8, comprising a ceramic material (12, 16) with a composition comprising 94 to 98 vol-% aluminum oxide, Al₂O₃, and 2 to 6 vol-% copper oxide, Cu₂O.

10. Carrier substrate (33, 35, 45) according to claim 8 or 9, produced by sintering at temperatures between 1000°C and 1800°C.

11. Carrier substrate (33, 35, 45) according to one of claims 8 to 10, produced by sintering at temperatures between 1100°C and 1300°C.

12. Use of a ceramic material (12, 16) with a composition comprising 85 to 99% vol-% of aluminum oxide, Al₂O₃, and 1 to 15% vol-% of copper oxide, Cu₂O, as a carrier substrate (33, 35, 45), for a circuit carrier (43, 55),
**characterized in**
**that** the proportions of aluminum oxide, Al₂O₃, and copper oxide, Cu₂O, add up to 100% vol-%, taking into account usual impurities.

13. Use of a ceramic material (12, 16) according to claim 12 with a composition comprising 94 to 98 vol-% aluminum oxide, Al₂O₃, and 2 to 6 vol-% copper oxide, Cu₂O.

14. Ceramic material (12, 16) for a carrier substrate (33, 35, 45) of a circuit carrier (43, 55) with a composition comprising 85 to 99 vol-% aluminum oxide, Al₂O₃, and 1 to 15 vol-% copper oxide, Cu₂O,
**characterized in**
**that** the proportions of aluminum oxide, Al₂O₃, and copper oxide, Cu₂O, add up to 100% vol-%, taking into account usual impurities.

15. Ceramic material (12, 16) according to claim 14, comprising 94 to 98 vol-% aluminum oxide, Al₂O₃, and 2 to 6 vol-% copper oxide, Cu₂O.

16. Ceramic material (12, 16) according to claim 14 or 15, produced by sintering at temperatures between 1000°C and 1800°C.

17. Ceramic material according to one of claims 14 to 16, produced by sintering at temperatures between 1100°C and 1300°C.

## Revendications

1. Procédé de fabrication d'un support de circuit (43, 55), dans lequel un substrat de support (33, 35, 45) est fourni, dans lequel une structure (37, 47) pour un conducteur (40, 52) à appliquer est introduite au moyen d'un laser dans la surface (31, 39, 39) du substrat de support (33, 35, 45), dans lequel, en formant le support de circuit (43, 54), la structure (37, 47) est pourvue d'un revêtement métallique (41, 53) formant le conducteur (40, 52), et un matériau céramique (12, 16) est utilisé comme substrat de support (33, 35, 45),
**caractérisé en ce**
**que** le matériau céramique a une composition comprenant 85 à 99 % en volume d'oxyde d'aluminium, Al₂O₃, ainsi que 1 à 15 % en volume d'oxyde de cuivre, Cu₂O.

2. Procédé selon la revendication 1, dans lequel un matériau céramique (12, 16) avec une composition comprenant 94 à 98 % en volume d'oxyde d'aluminium, Al₂O₃, ainsi que 2 à 6 % en volume d'oxyde de cuivre, Cu₂O, est utilisé comme substrat de support (33, 35, 45)

3. Procédé selon la revendication 1 ou 2, dans lequel le substrat de support (33, 35, 45) est préparé par frittage à des températures comprises entre 1000°C et 1800°C.

4. Procédé selon l'une des revendications précédentes, dans lequel le substrat de support (33, 35, 45) est préparé par frittage à des températures comprises entre 1100°C et 1300°C.

5. Procédé selon l'une des revendications précédentes, dans lequel la structure conductrice (37, 47) est introduite dans la surface (31, 39, 39) du substrat de support (33, 35, 45) avec une puissance laser comprise dans une plage allant de 4 watts à 12 watts.

6. Procédé selon l'une des revendications précédentes, dans lequel la structure conductrice (37, 47) est introduite dans la surface (31, 39, 39) du substrat de support (33, 35, 45) à une vitesse laser comprise entre 0,75 m/s et 2,25 m/s.

7. Procédé selon l'une des revendications précédentes, dans lequel la structure conductrice (37, 47) est introduite dans la surface (31, 39, 39) du substrat de support (33, 35, 45) avec une fréquence d'impulsion laser comprise entre 60 kHz et 120 kHz.

8. Substrat de support (33, 35, 45) pour un support de circuit (43, 55), comprenant un matériau céramique (12, 16) avec une composition comprenant 85 à 99 % en volume d'oxyde d'aluminium, Al₂O₃, ainsi que 1 à 15 % en volume d'oxyde de cuivre, Cu₂O,
**caractérisé en ce**
**que** les proportions d'oxyde d'aluminium, Al₂O₃, et d'oxyde de cuivre, Cu₂O, se complètent à 100 % en volume, compte tenu des impuretés habituelles.

9. Substrat de support (33, 35, 45) selon la revendication 8, comprenant un matériau céramique (12, 16) avec une composition comprenant 94 à 98 % en volume d'oxyde d'aluminium, Al₂O₃, ainsi que 2 à 6 % en volume d'oxyde de cuivre, Cu₂O.

10. Substrat de support (33, 35, 45) selon la revendication 8 ou 9, obtenu par frittage à des températures comprises entre 1000°C et 1800°C.

11. Substrat de support (33, 35, 45) selon l'une des revendications 8 à 10, obtenu par frittage à des températures comprises entre 1100°C et 1300°C.

12. Utilisation d'un matériau céramique (12, 16) avec une composition comprenant 85 à 99 % en volume d'oxyde d'aluminium, Al₂O₃, ainsi que 1 à 15 % en volume d'oxyde de cuivre, Cu₂ O, comme substrat de support (33, 35, 45), pour un support de circuit (43, 55),
**caractérisé en ce**
**que** les proportions d'oxyde d'aluminium, Al₂O₃, et d'oxyde de cuivre, Cu₂O, se complètent à 100 % en volume, compte tenu des impuretés habituelles.

13. Utilisation d'un matériau céramique (12, 16) selon la revendication 12 avec une composition comprenant 94 à 98 % en volume d'oxyde d'aluminium, Al₂O₃, ainsi que 2 à 6 % en volume d'oxyde de cuivre, Cu₂O.

14. Matériau céramique (12, 16) pour un substrat de support (33, 35, 45) d'un support de circuit (43, 55) avec une composition comprenant 85 à 99 % en volume d'oxyde d'aluminium, Al₂O₃, ainsi que 1 à 15 % en volume d'oxyde de cuivre, Cu₂O,
**caractérisé en ce**
**que** les proportions d'oxyde d'aluminium, Al₂O₃, et d'oxyde de cuivre, Cu₂O, se complètent à 100 % en volume, compte tenu des impuretés habituelles.

15. Matériau céramique (12, 16) selon la revendication 14, comprenant 94 à 98 % en volume d'oxyde d'aluminium, Al₂O₃, ainsi que 2 à 6 % en volume d'oxyde de cuivre, Cu₂O.

16. Matériau céramique (12, 16) selon la revendication 14 ou 15, obtenu par frittage à des températures comprises entre 1000°C et 1800°C.

17. Matériau céramique selon l'une des revendications 14 à 16, obtenu par frittage à des températures comprises entre 1100°C et 1300°C.
